# EUROPEAN PATENT SPECIFICATION

(11) **EP 4 307 380 B1**
(45) Date of publication and mention of the grant of the patent: **25.11.2026**
(21) Application number: 22778892.4
(22) Date of filing: 28.03.2022
(51) Int. Cl.: H10K 59/131, H05F 3/02, H10K 59/80

(54) **DISPLAY PANEL AND DISPLAY DEVICE**
ANZEIGETAFEL UND ANZEIGEVORRICHTUNG
ÉCRAN D'AFFICHAGE ET DISPOSITIF D'AFFICHAGE

(30) Priority: 02.04.2021 CN 202110362424
(43) Date of publication of application: 17.01.2024
(73) Proprietor: Huawei Technologies Co., Ltd., Shenzhen, Guangdong 518129 (CN)
(72) Inventor: GUO, Ligen, Shenzhen, Guangdong 518129 (CN); SUN, Tao, Shenzhen, Guangdong 518129 (CN)
(74) Representative: Pfenning, Meinig & Partner mbB
(86) International application number: PCT/CN2022/083511
(87) International publication number: WO 2022/206710

(56) References cited:
- WO-A1-2013/184956
- CN-A- 105 808 012
- CN-A- 109 839 783
- US-A1- 2015 303 223
- US-A1- 2018 203 553
- US-B2- 7 973 474

## Description

### TECHNICAL FIELD

This application relates to the field of display technologies, and in particular, to a display panel and a display apparatus.

### BACKGROUND

US 7 973 474 B2 describes an electroluminescent (EL) display, comprising: a substrate; an EL pixel array with a light emitting diode (LED) on the substrate; a connector electrically coupled to the EL pixel array; an encapsulant on the substrate, the encapsulant surrounding the EL pixel array; an encapsulation substrate opposing the substrate and disposed on the encapsulant, the EL pixel array being enclosed between the encapsulation substrate and the substrate; a conductive film electrically coupled to the connector, the conductive film being in communication with the encapsulation substrate, and the conductive film being disposed between the encapsulation substrate and the EL pixel array; and a ground connecting line electrically coupled between a ground line of the connector and the conductive film.

US 2018/203553 A1 describes a display module, comprising: a protection cover, a display panel and an electrostatic conducting layer, wherein the electrostatic conducting layer is disposed on a side of the protection cover facing the display panel and configured to conduct static electricity produced by the display module.

With the development of technologies, display technologies represented by a liquid crystal display (Liquid Crystal Display, LCD for short) and an organic light-emitting diode (Organic Light-Emitting Diode, OLED for short) technology compete with each other and change rapidly. An OLED display panel is a new development direction of a display panel after an LCD display panel, and has excellent features such as no backlight source, high contrast, a slight thickness, a wide viewing angle, a fast response speed, and a simple structure and manufacturing process.

In the OLED display panel, because an outermost glass substrate is likely to rub and generate static electricity in a use process, the static electricity is likely to enter the back of a light-emitting device, affecting a drive circuit and affecting a light-emitting effect of the light-emitting device. An electrostatic shielding layer is disposed on the OLED display panel to shield external static electricity. Specifically, a sample, a foam adhesive layer, and a copper foil are sequentially disposed on the back of the light-emitting device. The sample is configured to shape the light-emitting device, the foam adhesive layer is configured to perform a buffering function, and the copper foil is grounded for discharging back charges of the light-emitting device in time. This eliminates the static electricity. Alternatively, in a terminal device, a cover plate is connected to a middle frame by using a bonding adhesive, the bonding adhesive is an insulation material, the cover plate and the middle frame enclose a receptacle, the light-emitting device is located in the receptacle, and there is no conductivity between components.

However, the foregoing display panel apparatus has a poor shielding effect on the static electricity, and consequently the static electricity affects a display effect and even damages the drive circuit.

### SUMMARY

This application provides a display panel and a display apparatus, to improve a shielding effect of the display panel and the display apparatus on static electricity, and resolve a problem like a poor shielding effect of the display panel and apparatus on static electricity.

A first aspect of an embodiment of this application provides a display panel, including a light-emitting device and a cover plate. The cover plate covers a side of a light-emitting surface of the light-emitting device, a first shielding member is disposed on a side that is of the cover plate and that is away from the light-emitting device, and the first shielding member is grounded.

The display panel further includes a conductive member. A substrate and a buffer layer are disposed between the light-emitting device and the first shielding member, and the conductive member is electrically connected to the light-emitting device and the first shielding member.

According to the display panel provided in this application, the first shielding member is disposed, so that static electricity can be discharged in time through the first shielding member. This avoids impact on a light-emitting effect of the display panel due to accumulation of the static electricity in the display panel. The conductive member is disposed, so that static electricity between the light-emitting device and the buffer layer and static electricity between the buffer layer and the substrate can be discharged in time through the conductive member and the first shielding member. This avoids impact on normal operation of a drive circuit due to accumulation of the static electricity on the back of the light-emitting device. In addition, this improves a shielding effect of the display panel on the static electricity, prevents the static electricity from affecting a display effect, and protects the drive circuit.

Further, a first conductive layer is disposed on a surface that is of the substrate and that is close to one side of the light-emitting device, a second conductive layer is disposed on a surface that is of the substrate and that is close to one side of the buffer layer, and the substrate is provided with a first via. The first via communicates with the first conductive layer and the second conductive layer.

A third conductive layer is disposed in the first via, and two ends of the third conductive layer are electrically connected to the first conductive layer and the second conductive layer respectively.

The first conductive layer, the second conductive layer, and the third conductive layer form the conductive member.

The first conductive layer is disposed, so that static electricity between the substrate and the light-emitting device may be discharged. The second conductive layer is disposed, so that the static electricity between the substrate and the buffer layer may be discharged. The third conductive layer is disposed, so that static electricity between the first conductive layer and the second conductive layer may be discharged through the third conductive layer.

In a possible implementation of the first aspect, the buffer layer is a conductive layer.

In this way, the buffer layer may directly conduct static electricity of the third conductive layer and the second conductive layer to the first shielding member.

In a possible implementation of the first aspect, the buffer layer is a foam adhesive, and the foam adhesive is doped with conductive metal.

Two sides of the foam adhesive each are provided with a conductive adhesive.

In this way, two sides of the foam adhesive each are provided with the conductive adhesive, and the foam adhesive is doped with the conductive metal, so that the foam adhesive can not only perform bonding and buffering functions, but also perform a conductive function.

In a possible implementation of the first aspect, the buffer layer is an insulation layer.

In this way, the buffer layer mainly performs buffering and bonding functions.

In a possible implementation of the first aspect, the conductive member includes a fourth conductive layer, the buffer layer is provided with a second via, and the fourth conductive layer is disposed in the second via.

In this way, the second conductive layer and the third conductive layer may be electrically connected to the first shielding member through the fourth conductive layer, so that static electricity can be discharged.

In a possible implementation of the first aspect, the conductive member includes a fifth conductive layer, and the fifth conductive layer is located on a side edge of the light-emitting device.

An impedance of the fifth conductive layer ranges from 0 ohms to 1x10¹⁰ ohms.

In this way, the first conductive layer, the second conductive layer, and the first shielding member may be electrically connected through the fifth conductive layer on the side edge, and static electricity on the side edge may also be directly conducted to the first shielding member.

In a possible implementation of the first aspect, impedances of the first conductive layer, the second conductive layer, and the third conductive layer each ranges from 0 ohms to 1x10¹⁰ ohms.

Materials of the first conductive layer, the second conductive layer, and the third conductive layer each are indium tin oxide.

In this way, the substrate may be provided with the indium tin oxide through magnetron sputtering, to form the first conductive layer, the second conductive layer, and the third conductive layer.

In a possible implementation of the first aspect, an impedance of the buffer layer ranges from 0 ohms to 1x10¹⁰ ohms.

In this way, the buffer layer can conduct static electricity.

A second aspect of an embodiment of this application provides a display apparatus, including the display panel according to the first aspect. A second shielding member is disposed on a side that is of the cover plate and that is close to the light-emitting device, and the second shielding member is grounded.

A sixth conductive layer is disposed on the cover plate, the sixth conductive layer is located on the side that is of the cover plate and that is close to the light-emitting device, and the sixth conductive layer is electrically connected to the second shielding member.

According to the display apparatus provided in this application, the second shielding member is disposed, so that static electricity on the cover plate can be discharged in time through the second shielding member. This avoids accumulation of the static electricity on the cover plate. In addition, this may not only avoid impact of the static electricity on a user, but also avoid impact on normal operation and a light-emitting effect of a drive circuit of the light-emitting device due to migration of the static electricity from the cover plate to the "back" of the light-emitting device. The sixth conductive layer is disposed, so that the static electricity on the cover plate can be conducted to the second shielding member in time through the sixth conductive layer. This avoids accumulation of the static electricity on the cover plate and migration of the static electricity to the back of the light-emitting device, avoids affecting normal operation of the drive circuit, and improves a shielding effect of the display apparatus on the static electricity.

In a possible implementation of the second aspect, the display apparatus includes a middle frame, the middle frame is disposed on the side that is of the cover plate and that is close to the light-emitting device, the cover plate covers the middle frame, the cover plate and the middle frame enclose a receptacle, and the light-emitting device is disposed in the receptacle.

The middle frame forms the second shielding member.

In this way, the middle frame may be disposed as the second shielding member, so that an existing component structure is properly used. This reduces a quantity of disposed components, and enriches functions and effects of the middle frame.

In a possible implementation of the second aspect, a conductive adhesive is disposed between the middle frame and the cover plate, and the conductive adhesive connects the middle frame and the cover plate.

In this way, a connection part between the middle frame and the cover plate can have a conductive capability, and static electricity is conducted through the conductive adhesive.

In a possible implementation of the second aspect, the middle frame is a metal member, and the sixth conductive layer is electrically connected to the middle frame.

In this way, the middle frame has a conductive capability, and may be used as a conductive medium and a grounding medium of static electricity.

In a possible implementation of the second aspect, the middle frame is an insulating member, a seventh conductive layer is disposed on a side that is of the middle frame and that is close to the cover plate, and the seventh conductive layer is electrically connected to the sixth conductive layer.

In this way, static electricity can be conducted to a ground electrode through the seventh conductive layer.

In a possible implementation of the second aspect, a material of the sixth conductive layer is ink, and the ink is doped with conductive metal.

In this way, the conductive metal is doped, an impedance of the sixth conductive layer can be reduced, and conductivity of the sixth conductive layer can be improved.

In a possible implementation of the second aspect, impedances of the sixth conductive layer and the seventh conductive layer each ranges from 0 ohms to 1x10¹⁰ ohms.

In this way, the sixth conductive layer and the seventh conductive layer may have a capability of conducting static electricity. This facilitates static electricity conduction.

### BRIEF DESCRIPTION OF DRAWINGS

FIG. 1 is a schematic diagram of electrostatic induction of a display panel of a related technology according to an embodiment of this application;
FIG. 2 is a schematic diagram of a principle of a hole in a TFT according to an embodiment of this application;
FIG. 3 is a schematic diagram of a structure of a display panel of a related technology according to an embodiment of this application;
FIG. 4 is a schematic diagram of a partial structure of a mobile phone of a related technology according to an embodiment of this application;
FIG. 5 is a schematic diagram of a structure of a first shielding structure of a display panel according to an embodiment of this application;
FIG. 6 is a schematic diagram of a sectional structure of a substrate of a display panel according to an embodiment of this application;
FIG. 7 is a schematic diagram of a structure of a second shielding structure of a display panel according to an embodiment of this application;
FIG. 8 is a schematic diagram of a structure of a mobile phone including a middle frame, a cover plate and a light-emitting device according to an embodiment of this application;
FIG. 9 is a schematic diagram of a structure of a cover plate of a mobile phone according to an embodiment of this application;
FIG. 10 is a schematic diagram of a shielding structure of a mobile phone according to an embodiment of this application;
FIG. 11 is a schematic diagram of a structure of a mobile phone according to an embodiment of this application; and
FIG. 12 is an exploded view of a mobile phone according to an embodiment of this application.

Description of reference numerals:
100-display panel; 200-display apparatus; 1-battery; 2-circuit board;
3-rear cover; 10-light-emitting device; 11-base layer; 12-source;
13-gate; 14-drain; 15-copper foil; 16-source region;
17-drain region; 18-channel region; 20-cover plate; 30-substrate;
40-buffer layer; 50-first shielding member; 60-conductive member; 61-first conductive layer;
62-second conductive layer; 63-third conductive layer; 64-first via; 65-fifth conductive layer;
70-second shielding member; 80-sixth conductive layer; 90-middle frame; 91-bonding adhesive; and
92-conductive adhesive.

### DESCRIPTION OF EMBODIMENTS

Terms used in implementations of this application are merely used to explain specific embodiments of this application, but are not intended to limit this application.

In a field of display technologies, with development of the technologies, the display technologies represented by LCD and OLED technologies compete with each other and change with each passing day. An OLED display panel is a new development direction of a display panel after an LCD, and has excellent features such as no backlight source, high contrast, a slight thickness, a wide viewing angle, a fast response speed, and a simple structure and manufacturing process.

An OLED device includes a substrate, a cathode, an anode, a hole injection layer, an electron injection layer, a hole transport layer, an electron transport layer, an electron barrier layer, a hole barrier layer, a light-emitting layer, and the like. The substrate is a foundation of the entire device, and all functional layers need to be formed on the substrate of the device through evaporation deposition. The anode is connected to a positive electrode of an external drive voltage of the device. Driven by the external drive voltage, a hole in the anode moves to the light-emitting layer in the device. The anode needs to have specific light transmittance when the device works, so that light emitted from the inside of the device can be observed by the outside. Amost commonly used material of the anode is indium tin oxide. The hole injection layer can modify the anode of the device, and can smoothly inject a hole from the anode into the hole transport layer. The hole transport layer is responsible for transporting the hole to the light-emitting layer. The electron barrier layer blocks an electron from the cathode at an interface of the light-emitting layer of the device, to increase concentration of electrons at the interface of the light-emitting layer of the device. The light-emitting layer is a place in which the electron and the hole of the device recombine to form an exciton and then the exciton de-excites and emits light. The hole barrier layer blocks the hole from the anode at the interface of the light-emitting layer of the device. This increases a probability of recombination of the electron and the hole at the interface of the light-emitting layer of the device, and increases light-emitting efficiency of the device. The electron transport layer is responsible for transporting the electron from the cathode to the light-emitting layer of the device. The electron injection layer is used to modify the cathode and transport the electron to the electron transport layer. Driven by the external drive voltage of the device, the electron in the cathode move to the light-emitting layer of the device, and then recombines with the hole from the anode at the light-emitting layer.

A structure of the LCD is that a liquid crystal cell is arranged between two parallel glass substrates, a thin film transistor is disposed on lower substrate glass, and a color filter is disposed on upper substrate glass. A rotation direction of a liquid crystal molecule is controlled by changing a signal and voltage on the thin film transistor, to control emitting of polarized light at each pixel point and achieve a purpose of display.

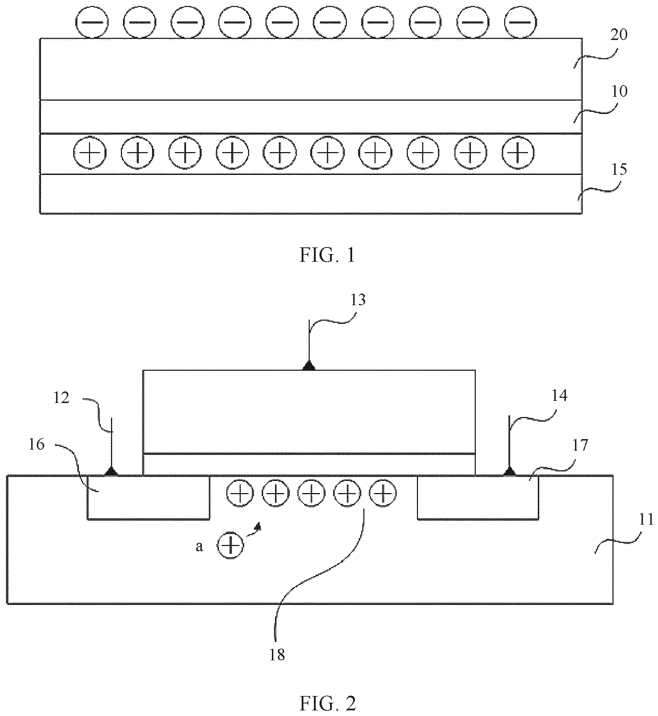

As shown in FIG. 1, in an OLED display panel, because an outermost cover plate 20 is likely to rub and generate static electricity in a use process, the static electricity is likely to migrate to the "back" of a light-emitting device 10 due to a potential difference, and the "back" specifically refers to a side that is of the light-emitting device 10 and that is away from a light-emitting surface. As shown in FIG. 2, a gate electrode 13 is used to apply a voltage, and static electricity is induced to form a hole in a base layer 11 of a thin film transistor (Thin Film Transistor, TFT), and a in the figure represents the induced hole. When the gate electrode 13 applies the voltage, the induced hole migrates to a channel region 18 in the base layer. Holes are accumulated in the channel region 18 between a source region 16 corresponding to a source 12 and a drain region 17 corresponding to a drain 14. This leads to a shift in a threshold voltage in a drive circuit. According to a current formula of the OLED: $I = \left(1/2\right) {C}_{OX} \left(μW/L\right) {\left({V}_{gs}-{V}_{th}\right)}^{2} ,$ in the formula, I represents a saturation current flowing through the OLED, *C_{OX}* represents a channel capacitance per unit area of the thin film transistor, µ represents a channel mobility, W represents a channel width, L represents a channel length, V_{gs} represents a voltage between a gate and a source, and Vₜₕ represents a threshold voltage.

It can be seen from the foregoing formula that, a change of the threshold voltage affects a change of the saturation current, and the change of the saturation current finally affects light-emitting brightness of a light-emitting layer. This leads to a poor display effect of the display panel.

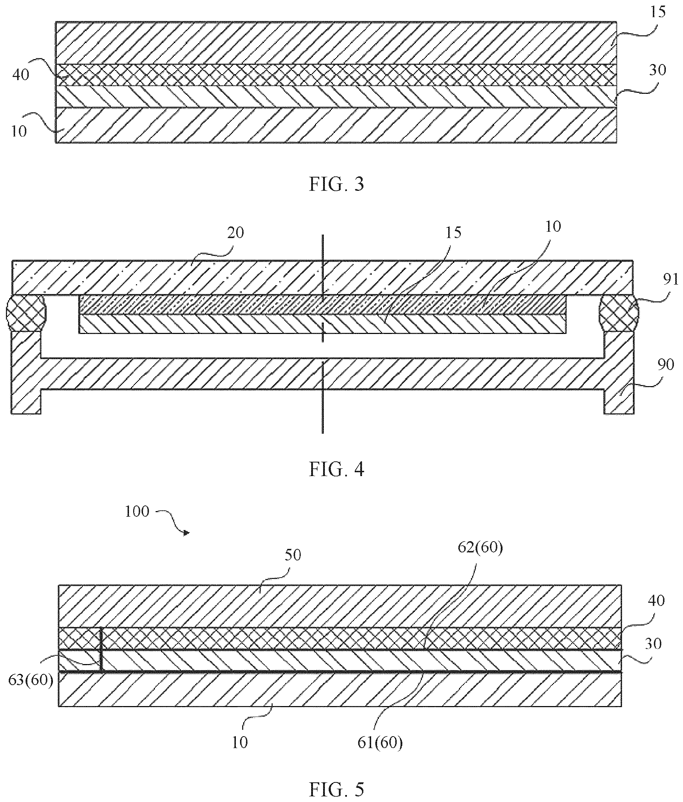

As shown in FIG. 3, in a technology related to the display panel, a copper foil 15 is generally disposed to shield external static electricity. Specifically, a substrate 30, a buffer layer 40 and the copper foil 15 are sequentially disposed on the "back" of a light-emitting device 10. The substrate 30 is configured to shape the light-emitting device 10, the buffer layer 40 is configured to perform buffering and bonding functions, and the copper foil 15 is grounded for discharging a "back" charge of the light-emitting device 10 in time. This eliminates the static electricity. However, because both the substrate 30 and the buffer layer 40 are made of insulation materials, the shielding structure cannot shield static electricity between the substrate 30 and the light-emitting device 10 and static electricity between the substrate 30 and the buffer layer 40. As a result, static electricity of the "back" of the light-emitting device 10 is not completely shielded, and a shielding effect is poor. Residual static electricity is still likely to affect a display effect and even damage a drive circuit.

In a technology related to a terminal, as shown in FIG. 4, a cover plate 20 of a mobile phone is connected to a middle frame 90 by using a bonding adhesive 91, and the bonding adhesive 91 is an insulation material. The cover plate 20 and the middle frame 90 enclose a receptacle, a light-emitting device 10 is located in the receptacle, and there is no conductivity between components. After the cover plate 20 rubs in a use process and generates static electricity, the static electricity is likely to be accumulated on an outer surface of the cover plate 20, so that a finger of a user is likely to be in contact with the static electricity. This affects use experience. In addition, the static electricity is likely to migrate from the outer surface of the cover plate 20 to the "back" of the light-emitting device 10. Consequently, a threshold voltage of a drive circuit is affected, and light-emitting brightness and a display effect are further affected.

### Embodiment 1

To resolve the foregoing problem, this application provides a display panel. The display panel 100 may be used in an electronic device. The electronic device may include but is not limited to mobile or fixed terminals with the display panel 100, for example, a mobile phone, a tablet computer, a notebook computer, an ultra-mobile personal computer (ultra-mobile personal computer, UMPC for short), a handheld computer, a walkie-talkie, a netbook, a POS terminal, a personal digital assistant (personal digital assistant, PDAfor short), a wearable device, and a virtual reality device. In this embodiment, the electronic device is described by using the mobile phone as an example.

Specifically, as shown in FIG. 5, the display panel 100 may include a light-emitting device 10 and a cover plate 20. The cover plate 20 covers a side of a light-emitting surface of the light-emitting device 10. A first shielding member 50 is disposed on a side that is of the cover plate 20 and that is away from the light-emitting device 10, and the first shielding member 50 is grounded. The display panel 100 further includes a conductive member 60, a substrate 30 and a buffer layer 40 are disposed between the light-emitting device 10 and the first shielding member 50, and the conductive member 60 is electrically connected to the light-emitting device 10 and the first shielding member 50. In this way, static electricity on a "back" side of the light-emitting device 10 may be conducted to the first shielding member 50 through the conductive member 60, to be specific, the "back" side is a side that is of the light-emitting device 10 and that is away from the cover plate 20. Static electricity between the light-emitting device 10 and the substrate 30 and static electricity between the substrate 30 and the buffer layer 40 may be conducted to the first shielding member 50 in time. This avoids impact on normal operation of a drive circuit due to accumulation of static electricity on the "back" of the light-emitting device 10.

It should be noted that, that the first shielding member 50 is grounded means that the first shielding member 50 is electrically connected to a negative electrode of a mobile phone, so that static electricity can flow into the negative electrode in time through the first shielding member 50. This prevents the static electricity from affecting the drive circuit.

It should be noted that the first shielding member 50 in this application is a copper foil. The copper foil is a negative electrolyte material, can be used within a wide temperature range, has excellent conductivity, and can provide good electromagnetic shielding and anti-static effects.

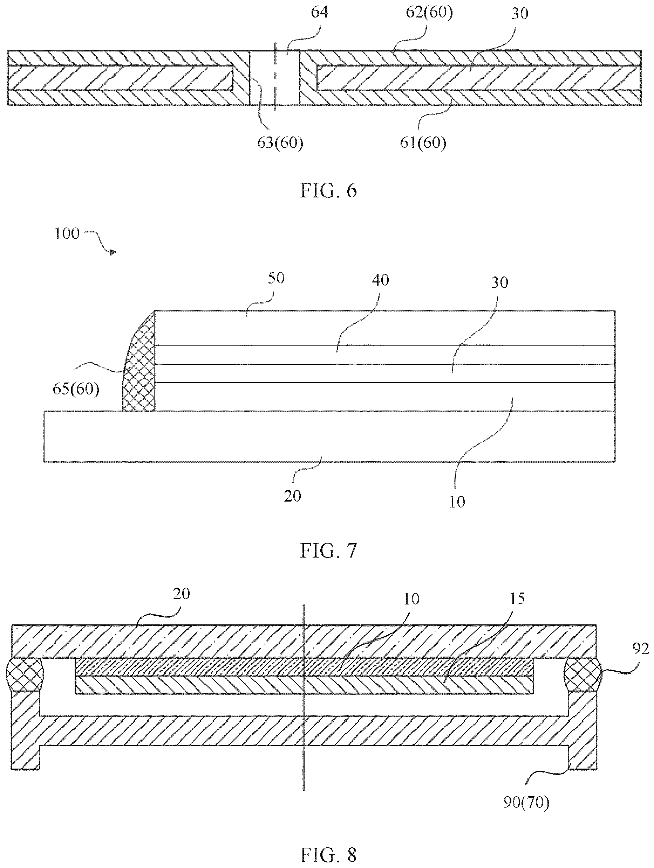

As shown in FIG. 6, a first conductive layer 61 is disposed on a surface that is of the substrate 30 and that is close to one side of the light-emitting device 10, a second conductive layer 62 is disposed on a surface that is of the substrate 30 and that is close to one side of the buffer layer 40, and a first via 64 is further disposed on the substrate 30. The first via 64 communicates with the first conductive layer 61 and the second conductive layer 62. A third conductive layer 63 is disposed in the first via 64, and two ends of the third conductive layer 63 are electrically connected to the first conductive layer 61 and the second conductive layer 62 respectively.

The first conductive layer 61 is disposed, so that static electricity between the substrate 30 and the light-emitting device 10 can be conducted through the first conductive layer 61. The second conductive layer 62 is disposed, so that static electricity between the substrate 30 and the buffer layer 40 can be conducted through the second conductive layer 62. The third conductive layer 63 is disposed, so that static electricity between the first conductive layer 61 and the second conductive layer 62 can be conducted through the third conductive layer 63. Specifically, a conduction path of the static electricity between the substrate 30 and the light-emitting device 10 may be successively the first conductive layer 61, the third conductive layer 63, the second conductive layer 62, the buffer layer 40, and the first shielding member 50; a conduction path of the static electricity between the substrate 30 and the buffer layer 40 may be successively the second conductive layer 62, the buffer layer 40, and the first shielding member 50; and a conduction path of static electricity between the buffer layer 40 and the first shielding member 50 may be directly conducted to the first shielding member 50.

In a possible implementation, the buffer layer 40 may be a conductive layer. In this way, the buffer layer 40 may directly conduct static electricity of the third conductive layer 63 and the second conductive layer 62 to the first shielding member 50.

In a possible implementation, the buffer layer 40 may be a foam adhesive, and a thickness of the foam adhesive may be between 50 um and 100 um. In this way, a thickness of the display panel 100 can be reduced as much as possible. The foam adhesive may be doped with conductive metal, and two sides of the foam adhesive each may be provided with a conductive adhesive. In this way, the first shielding member 50 and the substrate 30 may be bonded by using the foam adhesive. The two sides of the foam adhesive each are provided with the conductive adhesive, and the foam adhesive is doped with the conductive metal, so that the foam adhesive can not only perform bonding and buffering functions, but also perform a conductive function.

It should be noted that the foam adhesive is made of ethylene-vinyl acetate copolymer (ethylene-vinyl acetate copolymer, EVA for short) or is made of polyethylene (polyethylene, PE for short) foam that is coated with a solvent-type (or hot-melt-type) pressure-sensitive adhesive on one or two sides of the polyethylene foam and then covered with a release paper. The foam adhesive has excellent sealing performance and excellent compression deformation resistance. This can ensure long-term shockproof protection of fittings. The foam adhesive has flame retardancy, does not contain harmful toxic substances, does not pollute equipment, and does not corrode metal. In addition, the foam adhesive has excellent wettability, and is easy to paste, manufacture and die cut. Specifically, before pasting, dust or oil stains on surfaces of the substrate 30 and the light-emitting device 10 should be removed, and the surfaces are kept dry. During the pasting, an operating temperature should not be lower than 10°C, and after the pasting, the substrate 30 and the light-emitting device 10 should be kept still for 24 hours.

It should be noted that the conductive metal doped in the foam adhesive may be nickel, copper, aluminum, or the like, so that the foam adhesive has a conductive function. A specific type of the conductive metal is not limited in this embodiment of this application.

In a possible implementation, the buffer layer 40 may be an insulation layer. Two sides of the insulation layer may be provided with a bonding adhesive. In this way, the buffer layer 40 may perform buffering and bonding functions.

In a possible implementation, the conductive member 60 may further include a fourth conductive layer, the buffer layer 40 is provided with a second via, and the fourth conductive layer is disposed in the second via. In this way, the second conductive layer 62 and the third conductive layer 63 may be connected to the first shielding member 50 through the fourth conductive layer, so that static electricity can be discharged in time.

It should be noted that, a main function of filling the third conductive layer 63 in the first via 64 is to implement electrical conduction between the first conductive layer 61 and the second conductive layer 62, and a main function of filling the fourth conductive layer in the second via is to implement electrical conduction between the second conductive layer 62 and the first shielding member 50. In this way, static electricity of different conductive layers can be quickly conducted to the first shielding member 50, and an electrostatic shielding effect of the conductive member 60 and the first shielding member 50 is enhanced. Specifically, there may be a plurality of first vias 64 and a plurality of second vias, and the first vias 64 and the second vias may be evenly arranged on the substrate 30 and the buffer layer 40. In this way, a conductive effect between an upper layer and a lower layer may be better.

In a possible implementation, as shown in FIG. 7, the conductive member 60 may further include a fifth conductive layer 65, and the fifth conductive layer 65 is located on a side edge of the light-emitting device 10. Specifically, the fifth conductive layer 65 may be disposed on a periphery of the light-emitting device 10, and the fifth conductive layer 65 may be electrically connected to the light-emitting device 10, the substrate 30, the buffer layer 40, and the first shielding member 50 in sequence. Static electricity generated when the cover plate 20 rubs is migrated to the "back" of the light-emitting device 10 through the side edge of the light-emitting device 10. In this way, the migrated static electricity can be directly conducted to the first shielding member 50 through the fifth conductive layer 65, to avoid impact on normal operation of the light-emitting device 10 due to migration of the static electricity to the "back" of the light-emitting device 10. In addition, the fifth conductive layer 65 may also enable the first conductive layer 61, the second conductive layer 62, the buffer layer 40, and the first shielding member 50 to be electrically connected to each other, so that static electricity is quickly conducted to the first shielding member 50.

It should be noted that the fifth conductive layer 65 may be inorganic substance like poly (3, 4-ethylenedioxythiophene)-poly (styrene sulfonate) or polyethylenedioxythiophene-poly (styrene sulfonate), or may be metal like silver paste, ink, aluminum, copper, or gold. A specific material of the fifth conductive layer 65 is not limited in this embodiment of this application.

Specifically, an impedance of the fifth conductive layer 65 ranges from 0 ohms to 1x10¹⁰ ohms, and the impedance falls within the foregoing range, so that it can be ensured that the fifth conductive layer 65 conducts static electricity in time. This prevents the static electricity from staying concentrated.

In a possible implementation, impedances of the first conductive layer 61, the second conductive layer 62, and the third conductive layer 63 each ranges from 0 ohms to 1x10¹⁰ ohms, and the impedances fall within the foregoing range, so that it can be ensured that the first conductive layer 61, the second conductive layer 62, and the third conductive layer 63 conduct static electricity in time. This prevents the static electricity from staying concentrated.

Specifically, materials of the first conductive layer 61, the second conductive layer 62, and the third conductive layer 63 may be indium tin oxide.

It should be noted that the indium tin oxide (Indium tin oxide, ITO for short) is a mixture of indium (III group) oxide (In₂O₃) and tin (IV group) oxide (SnO₂). The ITO has good conductivity and transparency. The ITO is transparent and colorless in a thin film shape, and is yellow-to-gray in a block shape. The ITO has two performance indexes: resistivity and transmittance. The resistivity and transmittance of the ITO are controlled by a ratio of In₂O₃ to Sn₂O₃. An indium tin oxide coating may be deposited on a surface of the substrate 30 through electron beam evaporation, physical vapor deposition, or sputtering deposition.

Specifically, a magnetron sputtering method may be used. The magnetron sputtering is a type of physical vapor deposition, and has advantages such as simple equipment, easy control, large coating area, and strong adhesion. A working principle of the magnetron sputtering is that an electron collides with an argon atom in a process of flying to a substrate under the action of electric field E, so that the electron ionizes to generate Ar positive ions and new electrons. The new electrons fly to the substrate, and the Ar ions accelerate to a cathode target under the action of electric field, and bombard a surface of the target with high energy, so that a target material sputters. In sputtered particles, neutral target atoms or molecules are deposited on the substrate to form a thin film. Generated secondary electrons are affected by the electric field and a magnetic field, and drift in a direction indicated by E (the electric field)xB (the magnetic field). A movement track of the secondary electrons is similar to a cycloid. If the magnetic field is an annular magnetic field, the electron moves around a target surface in a form of an approximate cycloid. A movement path is not only long, but also limited to a plasma area near the target surface. In addition, a large quantity of Ars are ionized in the area to bombard the target material. This achieves a high deposition rate. As a quantity of collisions increases, energy of the secondary electrons is exhausted, gradually away from the target surface, and finally deposited on the substrate under the action of the electric field E. Because the energy of the electron is very low, the energy transferred to the substrate is very small, so that a temperature rise of the substrate is low.

In a possible implementation, an impedance of the buffer layer 40 ranges from 0 ohms to 1x10¹⁰ ohms. This can ensure that the buffer layer 40 can discharge static electricity in time, and avoid the static electricity from staying concentrated.

It should be noted herein that, in a process of disposing the first conductive layer 61, the second conductive layer 62, the third conductive layer 63, the fourth conductive layer, the fifth conductive layer 65, and the buffer layer 40, a uniform conductive structure of each conductive layer should be ensured as much as possible, so that an impedance of each conductive layer is uniform. This avoids a large difference between impedance values of different areas. If a difference between impedances of different areas at each conductive layer is large, static electricity in an area with a small impedance is likely to be conducted out, however, static electricity in an area with a large impedance is difficult to be conducted out, or a conduction process is slow. In this way, static electricity that is slowly conducted affects a drive circuit of the light-emitting device 10. This affects a light-emitting effect.

In this embodiment of this application, the display panel 100 may be a flexible OLED, a rigid OLED, or an LCD. A specific type of the display panel 100 is not limited in this embodiment of this application.

The OLED is mainly driven by an electric field, and an organic semiconductor material and a luminous material emit light through carrier injection and recombination. In essence, an ITO glass transparent electrode is used as an anode of a device, and a metal electrode is used as a cathode. An electron is transported from the cathode to an electron transport layer through power supply driving. A hole is injected from the anode to a hole transport layer, and then is migrated to a light-emitting layer. After the electron meets the hole, excitons are generated, and light-emitting molecules are excited. After radiation, a light source is generated.

It should be noted that, in a flexible OLED, the substrate 30 may be a bendable plastic substrate, for example, a polyethylene terephthalate (polyethylene terephthalate, PET for short) film or polyimide (Polyimide, PI for short), and a thickness may be 50 um to 150 um. In this way, a thickness of the display panel 100 may be reduced to a maximum extent. During packaging, the flexible OLED is packaged by using a polymer cover plate and a special film, so that a screen can maintain a bending capability and a folding feature, and has high reliability. In the rigid OLED, the substrate 30 may be a glass substrate.

It should be noted that the display panel 100 may further include a touch module, the touch module may be located between the cover plate 20 and the light-emitting device 10, and the touch module is configured to receive touch information entered by the user.

According to the display panel 100 provided in this embodiment of this application, the conductive member 60 is disposed in the substrate 30 and the buffer layer 40, so that static electricity between the light-emitting device 10 and the buffer layer 40 and static electricity between the buffer layer 40 and the substrate 30 can be discharged in time through the conductive member 60 and the first shielding member 50, to avoid accumulation of static electricity on the "back" of the light-emitting device 10. This not only has a good electrostatic shielding effect, but also has advantages such as small process modification, low difficulty, and low costs.

### Embodiment 2

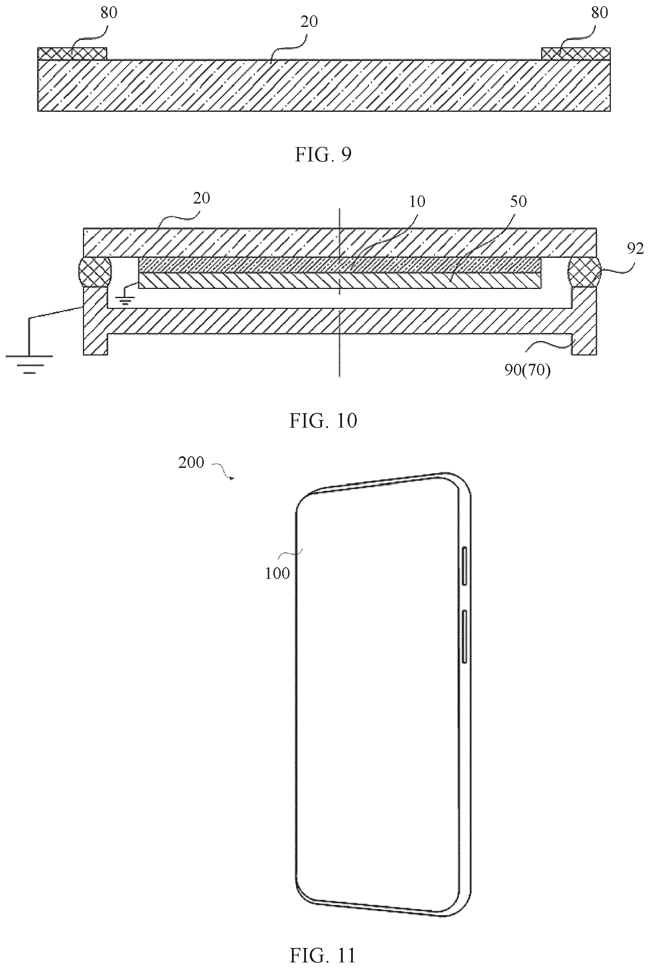

To resolve the foregoing problem, this application provides a display apparatus comprising the display panel according to the claims. The display apparatus 200 may be a mobile or fixed terminal with the display panel 100, for example, a mobile phone, a tablet computer, a notebook computer, a UMPC, a handheld computer, a walkie-talkie, a netbook, a POS terminal, a PDA, a wearable device, or a virtual reality device, or may be used as indoor and outdoor general lighting, a backlight source, or a decorative light, or may even be an artistic and flexible light-emitting wallpaper, a window that can emit light in a single color or color, a wearable luminous warning sign, or the like. In this embodiment, as shown in FIG. 11, the display apparatus 200 is described by using the mobile phone as an example.

Specifically, as shown in FIG. 8, the display apparatus 200 may include the light-emitting device 10 and the cover plate 20. The cover plate 20 covers a side of a light-emitting surface of the light-emitting device 10, a second shielding member 70 is disposed on a side that is of the cover plate 20 and that is close to the light-emitting device 10, and the second shielding member 70 is grounded. As shown in FIG. 9, a sixth conductive layer 80 is disposed on the cover plate 20, the sixth conductive layer 80 is located on the side that is of the cover plate 20 and that is close to the light-emitting device 10, and the sixth conductive layer 80 is electrically connected to the second shielding member 70.

It should be noted that, that the second shielding member 70 is grounded means that the second shielding member 70 is electrically connected to a negative electrode of the mobile phone, so that static electricity can flow into the negative electrode in time through the second shielding member 70. This prevents the static electricity from affecting a drive circuit.

The second shielding member 70 is disposed, so that static electricity on the cover plate 20 can be discharged in time through the second shielding member 70. This avoids accumulation of the static electricity on the cover plate 20. In addition, this may not only avoid impact of the static electricity on a user, but also avoid impact on normal operation and a light-emitting effect of the drive circuit of the light-emitting device 10 due to migration of the static electricity from the cover plate 20 to the "back" of the light-emitting device 10. The sixth conductive layer 80 is disposed, so that the static electricity on the cover plate 20 can be conducted to the second shielding member 70 in time through the sixth conductive layer 80. This avoids accumulation of the static electricity on the cover plate 20 and migration of the static electricity to the "back" of the light-emitting device 10, avoids affecting normal operation of the drive circuit, and improves a shielding effect of the display apparatus 200 on the static electricity.

In a possible implementation, the display apparatus 200 further includes a middle frame 90. The middle frame 90 is disposed on the side that is of the cover plate 20 and that is close to the light-emitting device 10. The cover plate 20 covers the middle frame 90, the cover plate 20 and the middle frame 90 enclose a receptacle, and the light-emitting device 10 is disposed in the receptacle. The middle frame 90 forms the second shielding member 70.

In this way, the middle frame 90 is disposed as the second shielding member 70, so that an existing component structure can be properly used. This reduces a quantity of disposed components, and enriches functions and effects of the middle frame 90. In this way, the middle frame 90 may not only be used as a frame of the mobile phone, but also shield static electricity on the mobile phone, to improve an electrostatic shielding effect of the mobile phone, and prevent the static electricity from affecting a display effect of the display panel 100.

It should be noted that a conductive apparatus may also be disposed in the mobile phone. One end of the conductive apparatus is electrically connected to the sixth conductive layer 80, and the other end of the conductive apparatus is grounded. A specific manner of disposing the second shielding member 70 is not limited in this embodiment of this application.

In a possible implementation, a conductive adhesive 92 is disposed between the middle frame 90 and the cover plate 20, and the conductive adhesive 92 connects the middle frame 90 and the cover plate 20.

In this way, not only the middle frame 90 and the cover plate 20 may be connected by using the conductive adhesive 92, but also a connection part between the middle frame 90 and the cover plate 20 may have a conductive capability, and static electricity is conducted through the conductive adhesive 92.

It should be noted that, the conductive adhesive is an adhesive that has specific conductivity after being cured or dried. The conductive adhesive can connect a plurality of conductive materials, so that the connected materials form a channel of electricity. Before the conductive adhesive is cured or dried, conductive particles separately exist in the adhesive, and do not contact each other continuously. Therefore, the conductive adhesive is in an insulated state. After the conductive adhesive is cured or dried, a volume of the adhesive shrinks due to volatilization of a solvent and curing of the adhesive, so that the conductive particles are stably in a continuous state with each other. This shows conductivity.

It should be noted that, according to a curing system, the conductive adhesive may be further classified into a room-temperature cured conductive adhesive, a medium-temperature cured conductive adhesive, a high-temperature cured conductive adhesive, an ultraviolet cured conductive adhesive, and the like. The room-temperature cured conductive adhesive is unstable, and volume resistivity is easy to change when the room-temperature cured conductive adhesive is stored at a room temperature. Metal particles are easy to oxidize when the high-temperature conductive adhesive is cured at a high temperature. Curing time needs to be short to meet a requirement of the conductive adhesive. The medium-temperature cured conductive adhesive (lower than 150°C) is widely used. A curing temperature of the conductive adhesive is moderate, matches a temperature resistance capability and a use temperature of an electronic component, and has excellent mechanical property. Therefore, the conductive adhesive is widely used. The conductive adhesive mainly includes a resin matrix, a conductive filler, a diluent, and the like. The matrix mainly includes epoxy resin, acrylate resin, polyurethane, and the like. The conductive filler may be gold, silver, copper, aluminum, zinc, iron, nickel powder and ink and some conductive compounds. Common solvents (or diluents) should have a large molecular weight and slow volatilization. In addition, a molecular structure should contain a polar structure like a carbon-oxygen polar chain. In addition to the resin matrix, conductive filler, and diluent, other components of the conductive adhesive, like an adhesive, also include crosslinking agent, coupling agent, preservative, toughening agent, thixotropic agent, and the like.

In a possible implementation, the middle frame 90 may be a metal member, and the sixth conductive layer 80 is electrically connected to the middle frame 90. In this way, the middle frame 90 has a conductive capability, and may be used as a conductive medium and a grounding medium of static electricity.

In a possible implementation, the middle frame 90 may be an insulating member, a seventh conductive layer may be disposed on a side that is of the middle frame 90 and that is close to the cover plate 20, and the seventh conductive layer is electrically connected to the sixth conductive layer 80. In this way, static electricity can be conducted to a ground electrode through the seventh conductive layer.

Specifically, the seventh conductive layer may be ITO, and is disposed on the middle frame 90 through magnetron sputtering.

It should be noted that a material of the middle frame 90 may be glass, plastic, ceramic, or the like. When the glass is used, the mobile phone is prone to break when falling. When the plastic is used, flatness of a plastic surface and texture after surface processing are likely to affect an appearance of the mobile phone. When the ceramic is used, a weight of the mobile phone is increased. In addition, the middle frame 90 may use a fiber reinforced polymer. The reinforced fiber may include but is not limited to a glass fiber, a carbon fiber, a boron nitride fiber, a silicon carbide fiber, an aluminum oxide fiber, a boron fiber and a zirconia fiber, an aramid fiber, or an ultra-high molecular weight polyethylene fiber, and a matrix material may be a plastic matrix. A specific material of the middle frame 90 is not limited in this embodiment of this application.

In a possible implementation, a material of the sixth conductive layer 80 may be ink, and the ink is doped with conductive metal.

In this way, the conductive metal is doped, an impedance of the sixth conductive layer 80 can be reduced, and conductivity of the sixth conductive layer 80 can be improved. The conductive metal may be powder of gold, silver, copper, aluminum, zinc, iron, or nickel. A specific type of the conductive metal is not limited in this embodiment of this application.

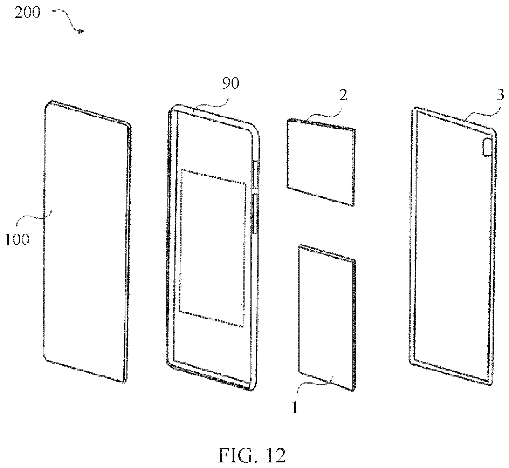

It should be noted that, as shown in FIG. 12, the mobile phone may further include a battery 1, a circuit board 2, and a rear cover 3. The circuit board 2 and the battery 1 may be disposed on the middle frame 90. For example, the circuit board 2 and the battery 1 are disposed on a side that is of the middle frame 90 and that faces the rear cover 3, or the circuit board 2 and the battery 1 may be disposed on a side that is of the middle frame 90 and that faces the display panel 100.

The circuit board 2 may be a printed circuit board (Printed circuit board, PCB for short), and the circuit board 2 has a chip, for example, a power amplifier, an application processor (Central Processing Unit, CPU for short), a power management chip (Power Management IC, PMIC for short), or a radio frequency chip.

The battery 1 may be connected to the circuit board 2 through a power management module (not shown) and a charging management module (not shown). The power management module receives inputs/an input of the battery 1 and/or the charging management module, and supplies power to a processor, an internal memory, an external memory, the display panel 100, a camera, a communication module, and the like. The power management module may be further configured to monitor parameters such as a capacity of the battery 1, a quantity of cycles of the battery 1, and a health status (leakage and an impedance) of the battery 1. In some other embodiments, the power management module may alternatively be disposed in a processor of the circuit board 2. In some other embodiments, the power management module and the charging management module may alternatively be disposed in a same component.

The rear cover 3 may be a metal rear cover, a glass rear cover, a plastic rear cover, or a ceramic rear cover. In this embodiment of this application, a material of the rear cover 3 is not limited.

It may be understood that the structure shown in this embodiment of this application does not constitute a specific limitation on the mobile phone. In some other embodiments of this application, the mobile phone may include more or fewer components than those shown in the figure, or may combine some components, or may split some components, or may have different component arrangements. For example, the mobile phone may further include components such as a camera (for example, a front-facing camera and a rear-facing camera) and a flash.

In a possible implementation, impedances of the sixth conductive layer 80 and the seventh conductive layer each ranges from 0 ohms to 1x10¹⁰ ohms. In this way, the sixth conductive layer 80 and the seventh conductive layer may have a capability of conducting static electricity. This facilitates static electricity conduction.

As shown in FIG. 10, the cover plate 20 is electrically connected to the ground middle frame 90, and an impedance ranges from 0 ohms to 1x10¹⁰ ohms, so that a shielding effect of the entire mobile phone can be implemented, and a display effect of the display panel 100 is not being affected by static electricity.

It should be noted that, when the electrostatic shielding structure in Embodiment 2 of this application is used, the shielding structure of the display panel 100 in Embodiment 1 of this application is also used, so that a shielding effect can be enhanced, and a shielding effect of the mobile phone is optimal. In FIG. 10, the substrate 30 and the buffer layer 40 are also disposed between the light-emitting device 10 and the first shielding member 50 of the display panel 100. A manner of disposing the conductive member 60 is the same as that in Embodiment 1 of this application, and is shown in detail in FIG. 10.

In descriptions of embodiments of this application, it should be noted that, unless otherwise clearly specified and limited, terms "installation", "connection", and "connected" should be understood in a broad sense. For example, the connection may be a fixed connection, may be an indirect connection through an intermediate medium, or may be an internal connection between two elements or an interaction relationship between two elements. For persons of ordinary skill in the art, specific meanings of the foregoing terms in embodiments of this application may be understood based on a specific situation.

In the specification, claims, and accompanying drawings of embodiments of this application, terms "first", "second", "third", "fourth", and the like (if exist) are intended to distinguish between similar objects but do not necessarily indicate a specific order or sequence.

## Claims

1. A display panel (100), comprising a light-emitting device (10) and a cover plate (20), wherein the cover plate (20) covers a side of a light-emitting surface of the light-emitting device (10), a first shielding member (50) is disposed on a side that is of the cover plate (20) and that is away from the light-emitting device (10), and the first shielding member (50) is grounded; and
the display panel (100) further comprises a conductive member (60), wherein a substrate (30) and a buffer layer (40) are disposed between the light-emitting device (10) and the first shielding member (50), and the conductive member (60) is electrically connected to the light-emitting device (10) and the first shielding member (50);
**characterized in that** a first conductive layer (61) is disposed on a surface that is of the substrate (30) and that is close to one side of the light-emitting device (10), a second conductive layer (62) is disposed on a surface that is of the substrate (30) and that is close to one side of the buffer layer (40), and the substrate (30) is provided with a first via (64), wherein the first via (64) communicates with the first conductive layer (61) and the second conductive layer (62);
a third conductive layer (63) is disposed in the first via (64), and two ends of the third conductive layer (63) are electrically connected to the first conductive layer (61) and the second conductive layer (62) respectively; and
the first conductive layer (61), the second conductive layer (62), and the third conductive layer (63) form the conductive member (60).

2. The display panel (100) according to claim 1, wherein the buffer layer (40) is a conductive layer.

3. The display panel (100) according to claim 2, wherein the buffer layer (400) is a foam adhesive, and the foam adhesive is doped with conductive metal; and
two sides of the foam adhesive each are provided with a conductive adhesive.

4. The display panel (100) according to claim 1, wherein the buffer layer (400) is an insulation layer.

5. The display panel (100) according to claim 4, wherein the conductive member (60) comprises a fourth conductive layer, the buffer layer (40) is provided with a second via, and the fourth conductive layer is disposed in the second via.

6. The display panel (100) according to any one of claims 1 to 5, wherein the conductive member (60) comprises a fifth conductive layer (65), and the fifth conductive layer (65) is located on a side edge of the light-emitting device (10); and
an impedance of the fifth conductive layer (65) ranges from 0 ohms to 1x10¹⁰ ohms.

7. The display panel (100) according to claim 1, wherein impedances of the first conductive layer (61), the second conductive layer (62), and the third conductive layer (63) each ranges from 0 ohms to 1x10¹⁰ ohms; and
materials of the first conductive layer (61), the second conductive layer (62), and the third conductive layer (63) each are indium tin oxide.

8. The display panel (100) according to claim 2 or 3, wherein an impedance of the buffer layer (40) ranges from 0 ohms to 1x10¹⁰ ohms.

9. A display apparatus (200), comprising the display panel (100) according to any one of claims 1 to 8, wherein a second shielding member (70) is disposed on a side that is of the cover plate (20) and that is close to the light-emitting device (10), and the second shielding member (70) is grounded; and
a sixth conductive layer (80) is disposed on the cover plate (20), the sixth conductive layer (80) is located on the side that is of the cover plate (20) and that is close to the light-emitting device (10), and the sixth conductive layer (80) is electrically connected to the second shielding member (70).

10. The display apparatus (200) according to claim 9, wherein the display apparatus (200) comprises a middle frame (90), the middle frame (90) is disposed on the side that is of the cover plate (20) and that is close to the light-emitting device (10), the cover plate (20) covers the middle frame (90), the cover plate (20) and the middle frame (90) enclose a receptacle, and the light-emitting device (10) is disposed in the receptacle; and
the middle frame (90) forms the second shielding member (70).

11. The display apparatus (200) according to claim 10, wherein a conductive adhesive (92) is disposed between the middle frame (90) and the cover plate (20), and the conductive adhesive (92) connects the middle frame (90) and the cover plate (20).

12. The display apparatus (200) according to claim 11, wherein the middle frame (90) is a metal member, and the sixth conductive layer (80) is electrically connected to the middle frame (90).

13. The display apparatus (200) according to claim 11, wherein the middle frame (90) is an insulating member, a seventh conductive layer is disposed on a side that is of the middle frame (90) and that is close to the cover plate (20), and the seventh conductive layer is electrically connected to the sixth conductive layer (80).

14. The display apparatus (200) according to any one of claims 9 to 13, wherein a material of the sixth conductive layer (80) is ink, and the ink is doped with conductive metal.

15. The display apparatus (200) according to claim 13, wherein impedances of the sixth conductive layer (80) and the seventh conductive layer each ranges from 0 ohms to 1x10¹⁰ ohms.

## Patentansprüche

1. Anzeigefeld (100), das eine lichtemittierende Vorrichtung (10) und eine Abdeckplatte (20) umfasst, wobei die Abdeckplatte (20) eine Seite einer lichtemittierenden Oberfläche der lichtemittierenden Vorrichtung (10) abdeckt, ein erstes Abschirmelement (50) auf einer Seite angeordnet ist, die zu der Abdeckplatte (20) gehört und die sich entfernt von der lichtemittierenden Vorrichtung (10) befindet, und das erste Abschirmelement (50) geerdet ist; und
das Anzeigefeld (100) ferner ein leitfähiges Element (60) umfasst, wobei ein Substrat (30) und eine Pufferschicht (40) zwischen der lichtemittierenden Vorrichtung (10) und dem ersten Abschirmelement (50) angeordnet sind und das leitfähige Element (60) mit der lichtemittierenden Vorrichtung (10) und dem ersten Abschirmelement (50) elektrisch verbunden ist;
**dadurch gekennzeichnet, dass** eine erste leitfähige Schicht (61) auf einer Oberfläche, die zu dem Substrat (30) gehört und die sich nahe einer Seite der lichtemittierenden Vorrichtung (10) befinde, angeordnet ist, eine zweite leitfähige Schicht (62) auf einer Oberfläche, die zu dem Substrat (30) gehört und die sich nahe einer Seite der Pufferschicht (40) befindet, angeordnet ist, und das Substrat (30) mit einer ersten Durchkontaktierung (64) bereitgestellt ist, wobei die erste Durchkontaktierung (64) mit der ersten leitfähigen Schicht (61) und der zweiten leitfähigen Schicht (62) in Verbindung steht;
eine dritte leitfähige Schicht (63) in der ersten Durchkontaktierung (64) angeordnet ist und zwei Enden der dritten leitfähigen Schicht (63) mit der ersten leitfähigen Schicht (61) beziehungsweise der zweiten leitfähigen Schicht (62) elektrisch verbunden sind; und
die erste leitfähige Schicht (61), die zweite leitfähige Schicht (62) und die dritte leitfähige Schicht (63) das leitfähige Element (60) ausbilden.

2. Anzeigefeld (100) nach Anspruch 1, wobei die Pufferschicht (40) eine leitfähige Schicht ist.

3. Anzeigefeld (100) nach Anspruch 2, wobei die Pufferschicht (400) ein Schaumklebstoff ist und der Schaumklebstoff mit leitfähigem Metall dotiert ist; und zwei Seiten des Schaumklebstoffs jeweils mit einem leitfähigen Klebstoff bereitgestellt sind.

4. Anzeigefeld (100) nach Anspruch 1, wobei die Pufferschicht (400) eine Isolierschicht ist.

5. Anzeigefeld (100) nach Anspruch 4, wobei das leitfähige Element (60) eine vierte leitfähige Schicht umfasst, die Pufferschicht (40) mit einer zweiten Durchkontaktierung bereitgestellt ist und die vierte leitfähige Schicht in der zweiten Durchkontaktierung angeordnet ist.

6. Anzeigefeld (100) nach einem der Ansprüche 1 bis 5, wobei das leitfähige Element (60) eine fünfte leitfähige Schicht (65) umfasst und die fünfte leitfähige Schicht (65) an einer Seitenkante der lichtemittierenden Vorrichtung (10) gelegen ist; und
eine Impedanz der fünften leitfähigen Schicht (65) von 0 Ohm bis 1x10¹⁰ Ohm reicht.

7. Anzeigefeld (100) nach Anspruch 1, wobei Impedanzen der ersten leitfähigen Schicht (61), der zweiten leitfähigen Schicht (62) und der dritten leitfähigen Schicht (63) jeweils von 0 Ohm bis 1x10¹⁰ Ohm reichen; und
Materialien der ersten leitfähigen Schicht (61), der zweiten leitfähigen Schicht (62) und der dritten leitfähigen Schicht (63) jeweils Indiumzinnoxid sind.

8. Anzeigefeld (100) nach Anspruch 2 oder 3, wobei eine Impedanz der Pufferschicht (40) von 0 Ohm bis 1x10¹⁰ Ohm reicht.

9. Anzeigeeinrichtung (200), die das Anzeigefeld (100) nach einem der Ansprüche 1 bis 8 umfasst, wobei ein zweites Abschirmelement (70) auf einer Seite, die zu der Abdeckplatte (20) gehört und die sich nahe der lichtemittierenden Vorrichtung (10) befindet, angeordnet ist, und das zweite Abschirmelement (70) geerdet ist; und
eine sechste leitfähige Schicht (80) auf der Abdeckplatte (20) angeordnet ist, die sechste leitfähige Schicht (80) auf der Seite, die zu der Abdeckplatte (20) gehört und die sich nahe der lichtemittierenden Vorrichtung (10) befindet, gelegen ist und die sechste leitfähige Schicht (80) mit dem zweiten Abschirmelement (70) elektrisch verbunden ist.

10. Anzeigeeinrichtung (200) nach Anspruch 9, wobei die Anzeigeeinrichtung (200) einen Mittelrahmen (90) umfasst, der Mittelrahmen (90) auf der Seite, die zu der Abdeckplatte (20) gehört und die sich nahe der lichtemittierenden Vorrichtung (10) befindet, angeordnet ist, die Abdeckplatte (20) den Mittelrahmen (90) abdeckt, die Abdeckplatte (20) und der Mittelrahmen (90) eine Aufnahme umgeben und die lichtemittierende Vorrichtung (10) in der Aufnahme angeordnet ist; und
der Mittelrahmen (90) das zweite Abschirmelement (70) ausbildet.

11. Anzeigeeinrichtung (200) nach Anspruch 10, wobei ein leitfähiger Klebstoff (92) zwischen dem Mittelrahmen (90) und der Abdeckplatte (20) angeordnet ist und der leitfähige Klebstoff (92) den Mittelrahmen (90) und die Abdeckplatte (20) verbindet.

12. Anzeigeeinrichtung (200) nach Anspruch 11, wobei der Mittelrahmen (90) ein Metallelement ist und die sechste leitfähige Schicht (80) mit dem Mittelrahmen (90) elektrisch verbunden ist.

13. Anzeigeeinrichtung (200) nach Anspruch 11, wobei der Mittelrahmen (90) ein isolierendes Element ist, eine siebte leitfähige Schicht auf einer Seite, die zu dem Mittelrahmen (90) gehört und die sich nahe der Abdeckplatte (20) befindet, angeordnet ist, und die siebte leitfähige Schicht mit der sechsten leitfähigen Schicht (80) elektrisch verbunden ist.

14. Anzeigeeinrichtung (200) nach einem der Ansprüche 9 bis 13, wobei ein Material der sechsten leitfähigen Schicht (80) Tinte ist und die Tinte mit leitfähigem Metall dotiert ist.

15. Anzeigeeinrichtung (200) nach Anspruch 13, wobei die Impedanzen der sechsten leitfähigen Schicht (80) und der siebten leitfähigen Schicht jeweils von 0 Ohm bis 1x10¹⁰ Ohm reichen.

## Revendications

1. Panneau d'affichage (100), comprenant un dispositif électroluminescent (10) et une plaque de recouvrement (20), dans lequel la plaque de recouvrement (20) recouvre un côté d'une surface électroluminescente du dispositif électroluminescent (10), un premier élément de blindage (50) est disposé sur un côté qui appartient à la plaque de recouvrement (20) et qui est éloigné du dispositif électroluminescent (10), et le premier élément de blindage (50) est mis à la terre ; et
le panneau d'affichage (100) comprend en outre un élément conducteur (60), dans lequel un substrat (30) et une couche tampon (40) sont disposés entre le dispositif électroluminescent (10) et le premier élément de blindage (50), et l'élément conducteur (60) est connecté électriquement au dispositif électroluminescent (10) et au premier élément de blindage (50) ;
**caractérisé en ce qu'**une première couche conductrice (61) est disposée sur une surface qui appartient au substrat (30) et qui est proche d'un côté du dispositif électroluminescent (10), une deuxième couche conductrice (62) est disposée sur une surface qui appartient au substrat (30) et qui est proche d'un côté de la couche tampon (40), et le substrat (30) est pourvu d'un premier trou d'interconnexion (64), dans lequel le premier trou d'interconnexion (64) communique avec la première couche conductrice (61) et la deuxième couche conductrice (62) ;
une troisième couche conductrice (63) est disposée dans le premier trou d'interconnexion (64), et deux extrémités de la troisième couche conductrice (63) sont connectées électriquement à la première couche conductrice (61) et à la deuxième couche conductrice (62) respectivement ; et
la première couche conductrice (61), la deuxième couche conductrice (62) et la troisième couche conductrice (63) forment l'élément conducteur (60).

2. Panneau d'affichage (100) selon la revendication 1, dans lequel la couche tampon (40) est une couche conductrice.

3. Panneau d'affichage (100) selon la revendication 2, dans lequel la couche tampon (400) est un adhésif en mousse, et l'adhésif en mousse est dopé avec un métal conducteur ; et
deux côtés de l'adhésif en mousse sont chacun pourvus d'un adhésif conducteur.

4. Panneau d'affichage (100) selon la revendication 1, dans lequel la couche tampon (400) est une couche isolante.

5. Panneau d'affichage (100) selon la revendication 4, dans lequel l'élément conducteur (60) comprend une quatrième couche conductrice, la couche tampon (40) est pourvue d'un second trou d'interconnexion, et la quatrième couche conductrice est disposée dans le second trou d'interconnexion.

6. Panneau d'affichage (100) selon l'une quelconque des revendications 1 à 5, dans lequel l'élément conducteur (60) comprend une cinquième couche conductrice (65), et la cinquième couche conductrice (65) est située sur un bord latéral du dispositif électroluminescent (10) ; et
une impédance de la cinquième couche conductrice (65) est comprise dans la plage allant de 0 ohm à 1 x 10¹⁰ ohms.

7. Panneau d'affichage (100) selon la revendication 1, dans lequel des impédances de la première couche conductrice (61), de la deuxième couche conductrice (62) et de la troisième couche conductrice (63) sont chacune comprises dans la plage allant de 0 ohm à 1 x 10¹⁰ ohms ; et
des matériaux de la première couche conductrice (61), de la deuxième couche conductrice (62) et de la troisième couche conductrice (63) sont chacun de l'oxyde d'indium-étain.

8. Panneau d'affichage (100) selon la revendication 2 ou 3, dans lequel une impédance de la couche tampon (40) est comprise dans la plage allant de 0 ohm à 1 x 10¹⁰ ohms.

9. Appareil d'affichage (200), comprenant le panneau d'affichage (100) selon l'une quelconque des revendications 1 à 8, dans lequel un second élément de blindage (70) est disposé sur un côté qui appartient à la plaque de recouvrement (20) et qui est proche du dispositif électroluminescent (10), et le second élément de blindage (70) est mis à la terre ; et
une sixième couche conductrice (80) est disposée sur la plaque de recouvrement (20), la sixième couche conductrice (80) est située sur le côté qui appartient à la plaque de recouvrement (20) et qui est proche du dispositif électroluminescent (10), et la sixième couche conductrice (80) est connectée électriquement au second élément de blindage (70).

10. Appareil d'affichage (200) selon la revendication 9, dans lequel l'appareil d'affichage (200) comprend un cadre central (90), le cadre central (90) est disposé sur le côté qui appartient à la plaque de recouvrement (20) et qui est proche du dispositif électroluminescent (10), la plaque de recouvrement (20) recouvre le cadre central (90), la plaque de recouvrement (20) et le cadre central (90) enferment un réceptacle, et le dispositif électroluminescent (10) est disposé dans le réceptacle ; et
le cadre central (90) forme le second élément de blindage (70).

11. Appareil d'affichage (200) selon la revendication 10, dans lequel un adhésif conducteur (92) est disposé entre le cadre central (90) et la plaque de recouvrement (20), et l'adhésif conducteur (92) relie le cadre central (90) et la plaque de recouvrement (20).

12. Appareil d'affichage (200) selon la revendication 11, dans lequel le cadre central (90) est un élément métallique, et la sixième couche conductrice (80) est connectée électriquement au cadre central (90).

13. Appareil d'affichage (200) selon la revendication 11, dans lequel le cadre central (90) est un élément isolant, une septième couche conductrice est disposée sur un côté qui appartient au cadre central (90) et qui est proche de la plaque de recouvrement (20), et la septième couche conductrice est connectée électriquement à la sixième couche conductrice (80).

14. Appareil d'affichage (200) selon l'une quelconque des revendications 9 à 13, dans lequel un matériau de la sixième couche conductrice (80) est de l'encre, et l'encre est dopée avec un métal conducteur.

15. Appareil d'affichage (200) selon la revendication 13, dans lequel des impédances de la sixième couche conductrice (80) et de la septième couche conductrice sont chacune comprises dans la plage allant de 0 ohm à 1 x 10¹⁰ ohms.
